# EUROPÄISCHE PATENTSCHRIFT

(11) **EP 1 050 201 B1**
(45) Veröffentlichungstag und Bekanntmachung des Hinweises auf die Patenterteilung: **10.04.2002**
(21) Anmeldenummer: 99907372.9
(22) Anmeldetag: 15.01.1999
(51) Int. Cl.: H05K 3/04

(54) **VERFAHREN UND VORRICHTUNG ZUM ROTATIVEN SCHNEIDEN VON PLATINEN UND ELEKTRISCHEN LEITERBAHNEN**
ROTATIVE CUTTING METHOD AND DEVICE FOR PRINTED CIRCUIT BOARDS AND ELECTRIC CONDUCTORS
PROCEDE ET DISPOSITIF POUR LE DECOUPAGE ROTATIF DE CARTES DE CIRCUITS IMPRIMES ET DE CIRCUITS CONDUCTEURS ELECTRIQUES

(30) Priorität: 24.01.1998 DE 19802512
(43) Veröffentlichungstag der Anmeldung: 08.11.2000
(73) Patentinhaber: SCHOBER GmbH Werkzeug- und Maschinenbau, D-71735 Eberdingen (DE)
(72) Erfinder: WITTMAIER, Klaus, D-71665 Vaihingen (DE)
(74) Vertreter: Steimle, Josef, Dipl.-Ing.
(86) Internationale Anmeldenummer: EP9900201
(87) Internationale Veröffentlichungsnummer: WO9938367

(56) Entgegenhaltungen:
- DE-A- 2 201 680
- GB-A- 1 135 982
- US-A- 3 473 218
- US-A- 3 547 724
- US-A- 3 713 944
- DATABASE WPI Week 8136 Derwent Publications Ltd., London, GB; AN 81-65316d XP002104759 & JP 56 034117 B (MATSUSHITA ELEC IND CO) , 7. August 1981

## Beschreibung

Die Erfindung betrifft ein Verfahren und eine Vorrichtung zum rotativen Schneiden von Platinen und elektrischen Leiterbahnen; (siehe z.B. GB-A-1 135 982).

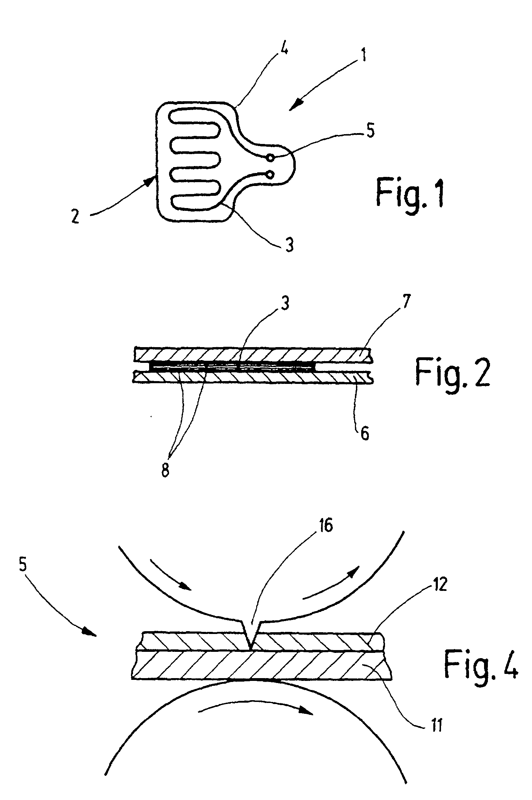

Die in Figur 1 dargestellten Produkte 1 sind flexible Leiterbahnen oder Platinen, die in mehrlagiger Ausführung und mit beliebigen Außenkonturen 2 vorkommen können. Auch die auf das Trägermaterial 4 aufgebrachte leitende Schicht 3, die in der Regel eine leitende Bahn ist, kann jede beliebige Form aufweisen und die Länge der leitenden Strecke kann beliebig sein. Ferner weist das Produkt 1 Anschlußstellen 5 z.B. in Form von Löchern auf.

Die leitende Schicht 3 befindet sich z.B. zwischen einer Unterschicht 6 und einer Ober- oder Deckschicht 7. Zwischen den Schichten 3, 7 und 7 befindet sich z.B. ein Haftmittel 8, was in Figur 2 dargestellt ist.

Bisher wurden diese Produkte 1 im galvanischen Verfahren hergestellt, d.h. daß die nicht benötigten Anteile der leitenden Bahn 3 werden weggeätzt, so daß die gewünschte Form stehen bleibt. Diese Herstellungsart ist aufwendig und umweltbelastend.

Ein zweites Verfahren zur Herstellung dieser Produkte 1 wird mit einem Flachmesser ausgeführt, bei dem die Kontur mit einem Ritzmesser auf die leitende Bahn aufgebracht wird und der nicht benötigte Teil abgezogen wird. Auch dieses Verfahren ist zeitaufwendig und teuer.

Beide genannten Verfahren haben noch den Nachteil, daß hauptsächlich mit Materialbögen gearbeitet wird und keine Endlosverarbeitung möglich ist.

Der Erfindung liegt daher die Aufgabe zugrunde ein Verfahren und/oder eine Vorrichtung zu schaffen, mit der derartige Produkte einfacher, preiswerter und umweltschonender hergestellt werden können.

Diese Aufgabe wird erfindungsgemäß mit einem Verfahren gelöst, welches die Merkmale des Anspruchs 1 aufweist. Außerdem wird diese Aufgabe durch eine Vorrichtung gemäß Anspruch 3 gelöst.

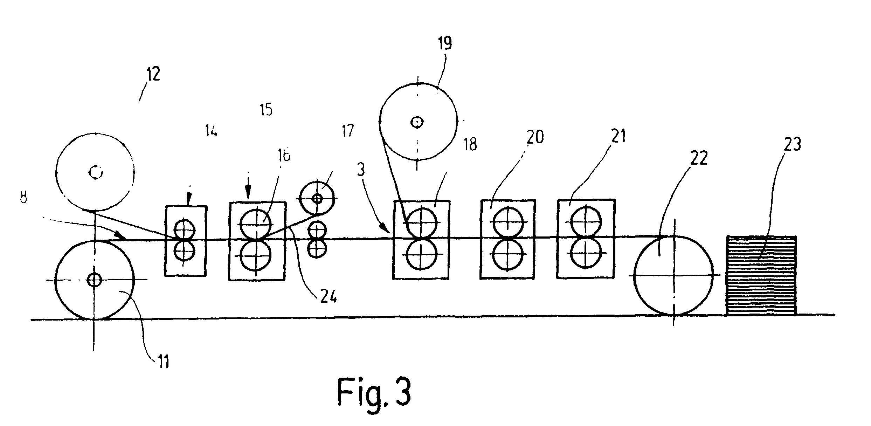

Unter Bezug auf die Figuren 3 und 4 wird das neue Verfahren näher erläutert. Die Figur 3 zeigt eine Vorrichtung zum rotativen Herstellen von Leiterplatten.

Beim erfindungsgemäßen Verfahren wird eine leitende Bahn 12 auf ein Grundmaterial 11 mit oder ohne Haftmittel 8 aufgebracht. Falls ein Haftmittel 8 benötigt wird, kann dieses mittels einer geeigneten Vorrichtung, z.B. einer Sprühdüse, einen Walze oder dergl. aufgetragen werden. Das Grundmaterial 11 kann das Haftmittel 8 bereits aufweisen und wird von einer Rolle abgerollt. Die Bahn 12 und das Grundmaterial 11 werden in eine Laminierstation 14 geführt, an welche sich eine Schneidstation 15 anschließt. In dieser befindet sich ein rotierendes Messer 16, in der Regel ein Schneidzylinder, das jede beliebige Form für die herzustellende leitende Bahn 3 aufweist. Die auf dem Trägermaterial 11 aufgebrachte leitende Schicht 12, die z.B. aus Kupfer oder Aluminium besteht, wird durch das rotierende Messer 16 getrennt bzw. in Form geschnitten, wogegen das Trägermaterial 11 nicht oder nur geringfügig angeschnitten wird.

Die durch das Messer 16 aufgebrachte Kontur entspricht derjenigen der tatsächlich benötigten leitenden Bahn 3. Das restliche Material verbleibt als Schneidabfall 24 gleichfalls auf dem Grundmaterial 11 und wird später entfernt oder, falls es sich um ein endloses Abfallgitter handelt, kann dieses unmittelbar nach dem Schneidprozess in einer Station 17 abgezogen werden.

Bei Produkten mit Deckschicht 7 wird der Abfall auf jeden Fall entfernt. Dies kann bei Endloskonturen durch ein Abziehen des Abfalls und Wiederaufrollen in der Station 17 durchgeführt werden oder durch eine spezielle vakuumunterstützte Abnahmestation für den Abfall. Anschließend wird das Grundmaterial 11 mit der leitenden Bahn 3 nochmals mittels einer Glättungseinrichtung an den Schnittkanten gewalzt. Im weiteren Verlauf wird die Deckschicht 7 von einer Rolle 19 abgerollt und in einer Laminierstation 18 auf die leitende Bahn 3 auflaminiert. Danach wird durch rotierende Stanzwerkzeuge 20 je nach Bedarfsfall eine beliebige Anzahl von Löchern (jede beliebige Form) in die Materialbahn eingebracht und abschließend wird das gesamte Produkt durch ein rotierendes Messer 21 in die gewünschte Endform gebracht. Entstehen dabei einzelne Stücke, werden diese nach der Schneidstation einer Einzelauslage 23 übernommen. Handelt es sich um ein endloses Produkt, wird diese Bahn auf eine Rolle 22 endlos aufgewickelt.

Eine Variante sieht vor, die leitende Schicht 12 mittels Ultraschall auf dem Trägermaterial 11, z.B. einer Kunststofffolie zu fixieren. Eine andere Variante sieht vor, das Trägermatrial 11 heißsiegelfähig zu lackieren und von der aufgebrachten leitenden Schicht 12 nur den der leitenden Bahn entsprechenden Teil zu fixieren. Der nicht fixierte Teil wird ausgeschnitten und als Abfallgitter in der Station 17 entfernt. Es ist auch denkbar, das Trägermaterial 11 mit einer leitenden Farbe oder Flüssigkeit, die das Kupfer oder das Aluminium enthält, zu bedrucken.

Figur 4 zeigt einen Ausschnitt aus der Schneidstation 15 in vergrößerter Darstellung. Deutlich sichtbar ist das Messer 16, das lediglich die leitende Schicht 12, jedoch nicht das Trägermaterial 11 durchtrennt.

Vorteile dieser Vorrichtung sind
a) der Herstellungsprozeß kann in einer Inline-Maschine vom Rohprodukt bis zum Fertigprodukt hergestellt werden;
b) die rotierenden Schneidmesser 16 und 21 erlauben eine wesentlich höhere Arbeitsgeschwindigkeit als bei den bekannten Verfahren;
c) statt eines rotierenden Schneidmessers 16 bzw. 21 kann auch ein Schneidblech auf einen Trägerzylinder aufgebracht werden;
d) das Verfahren ersetzt die umweltbelastenden Ätzverfahren:
e) die leitenden Rohmaterialien (Kupfer, Aluminium etc.) können in der vorliegenden Form direkt als Recyclingmaterial weiter verwendet werden.

## Patentansprüche

1. Verfahren zum Herstellen von Platinen und elektrischen Leiterbahnen, bei dem auf ein Trägermaterial (11) eine leitende Schicht (12) aufgebracht wird, die leitende Schicht (12) anschließend in einem rotativen Schneidprozeß mittels eines rotierenden Messers (15) geschnitten und der Schneidabfall (24) vom Trägermaterial abgezogen wird, **dadurch gekennzeichnet, dass** im Endlosverfahren eine Deckschicht (7) auf die ausgeschnittene leitende Schicht (12) auflaminiert wird und dass anschließend mittels rotierender Stanzwerkzeuge (20) Löcher (5) in die Materialbahn eingebracht werden und die Materialbahn mittels rotierender Messer (21) in die gewünschte Endform gebracht wird.

2. Verfahren nach Anspruch 1, **dadurch gekennzeichnet, daß** die leitende Schicht (12) wenigstens abschnittsweise mittels Ultraschall auf dem Trägermaterial (11) fixiert wird.

3. Vorrichtung zum Herstellen von Platinen und elektrischen Leiterbahnen, mit einer Station (14) in welcher eine leitende Schicht (12) auf einem Trägermaterial (11) fixiert wird, einer sich daran anschließenden Schneidstation (15) zum rotativen Schneiden der leitenden Schicht (12) in eine leitende Bahn (3) und einen Schneidabfall (24) und einer Station (17) zum Entfernen des Schneidabfalls (24), **gekennzeichnet durch** eine Laminierstation (18) zum Auflaminieren einer Deckschicht (7) auf das Trägermaterial (11) mit der leitenden Bahn (3), ein rotierendes Stanzwerkzeug (20) zum Einbringen von Löchern (5) in die Materialbahn und ein rotierendes Messer (21) zum Herstellen der gewünschten Endform.

4. Vorrichtung nach Anspruch 3, **dadurch gekennzeichnet, daß** die Fixierstation (14) eine Laminierstation ist.

5. Vorrichtung nach Anspruch 3, **dadurch gekennzeichnet, daß** die Fixierstation (14) eine Ultraschallvorrichtung aufweist, mit der die leitende Schicht (12) wenigstens abschnittsweise auf der Trägermaterial (11) fixiert wird.

6. Vorrichtung nach Anspruch 3, **dadurch gekennzeichnet, daß** die Fixierstation (14) eine Druckstation ist, mit der die leitende Schicht (12) in Form von flüssigem oder pastösem Material auf das Trägermaterial (11) aufgetragen wird.

## Claims

1. Process for producing printed circuit boards and electric conductors, in which a conductive layer (12) is applied to a carrier material (11), the conductive layer (12) is then cut in a rotative cutting method by means of a rotating blade (15) and the cutting waste (24) is removed from the carrier material, **characterised in that** an outer layer (7) is laminated onto the cut out conductive layer (12) in a continuous process and that holes (5) are then inserted into the material web by means of rotating punching dies (20) and the material web is then brought into the desired final form by means of rotating blades (21).

2. Process according to claim 1, **characterised in that** the conductive layer (12) is fixed, at least in portions, onto the carrier material (11) by means of ultrasound.

3. Device for producing printed circuit boards and electric conductors, with a station (14) in which a conductive layer (12) is fixed on a carrier material (11), a cutting station (15) adjacent thereto for the rotative cutting of the conductive layer (12) into a conductive web (3) and cutting waste (24) and a station (17) for removing the cutting waste (24), **characterised by** a laminating station (18) for laminating an outer layer (7) onto the carrier material (11) with the conductive web (3), a rotating punching die (20) for inserting holes (5) into the material web and a rotating blade (21) for producing the desired final form.

4. Device according to claim 3, **characterised in that** the fixing station (14) is a laminating station.

5. Device according to claim 3, **characterised in that** the fixing station (14) has an ultrasound device, with which the conductive layer (12) is fixed onto the carrier material (11) at least in portions.

6. Device according to claim 3, **characterised in that** the fixing station (14) is a pressure station, with which the conductive layer (12) is applied to the carrier material (11) in the form of liquid or pasty material.

## Revendications

1. Procédé de fabrication de cartes de circuits imprimés et de pistes conductrices électriques, dans lequel une couche conductrice (12) est appliquée sur une matière de support (11), la couche conductrice (12) est ensuite coupée dans un processus de coupe rotatif au moyen d'un couteau tournant (15) et la chute (24) de coupe de matière de support est enlevée, **caractérisé en ce qu'**une couche protectrice (7) est déposée par laminage dans un procédé continu sur la couche conductrice découpée (12), et que des orifices (5) sont ensuite pratiqués dans la piste de matière au moyen d'outils d'estampage tournants (20) et la piste de matière est amenée à la forme finale souhaitée au moyen de couteaux tournants (21).

2. Procédé selon la revendication 1, **caractérisé en ce que** la couche conductrice (12) est fixée au moins partiellement par ultrasons sur la matière de support (11).

3. Dispositif de fabrication de cartes de circuits imprimés et de pistes conductrices électriques, qui inclut une station (14) dans laquelle une couche conductrice (12) est fixée sur une matière de support (11), une station de coupe (15) disposée en aval de la précédente pour effectuer une coupe rotative de la couche conductrice (12) afin de former une piste conductrice (3) et une chute (24) de coupe, et une station (17) pour enlever la chute (24) de coupe, **caractérisé par** une station de laminage (18) pour déposer par laminage une couche protectrice (7) sur la matière de support (11) qui porte la piste conductrice (3), un outil d'estampage rotatif (20) pour pratiquer des orifices (5) dans la piste de matière et un couteau tournant (21) pour réaliser la forme finale souhaitée.

4. Dispositif selon la revendication 3, **caractérisé en ce que** la station de fixation (14) est une station de laminage.

5. Dispositif selon la revendication 3, **caractérisé en ce que** la station de fixation (14) comporte un dispositif ultrasonique au moyen duquel la couche conductrice (12) est fixée au moins partiellement sur la matière de support (11).

6. Dispositif selon la revendication 3, **caractérisé en ce que** la station de fixation (14) est une station d'impression au moyen de laquelle la couche conductrice (12) est appliquée sur la matière de support (11) sous forme de matière liquide ou de pâte.
